# EUROPÄISCHE PATENTSCHRIFT

(11) **EP 0 543 826 B1**
(45) Veröffentlichungstag und Bekanntmachung des Hinweises auf die Patenterteilung: **05.10.1994**
(21) Anmeldenummer: 91912598.9
(22) Anmeldetag: 12.07.1991
(51) Int. Cl.: F02D 41/30, H02H 9/04, H02H 7/00, G05F 1/571

(54) **VERFAHREN UND EINRICHTUNG ZUR ANSTEUERUNG EINES ELEKTROMAGNETISCHEN VERBRAUCHERS**
PROCESS AND DEVICE FOR DRIVING AN ELECTROMAGNETIC CONSUMER
PROCEDE ET DISPOSITIF D'EXCITATION D'UN CONSOMMATEUR ELECTOMAGNETIQUE

(30) Priorität: 18.08.1990 DE 4026224; 20.09.1990 DE 4029794
(43) Veröffentlichungstag der Anmeldung: 02.06.1993
(73) Patentinhaber: ROBERT BOSCH GMBH, 70442 Stuttgart (DE)
(72) Erfinder: GRAF, Herbert, D-7295 Dornstetten (DE); SCHWENGER, Juergen, D-7050 Waiblingen (DE); ZIMMERMANN, Werner, D-7000 Stuttgart 40 (DE); WICHERT, Bernd, D-7053 Kernen (DE); BIELESCH, Thomas, D-7130 Muehlacker 7 (DE)
(86) Internationale Anmeldenummer: DE9100572
(87) Internationale Veröffentlichungsnummer: WO9203646

(56) Entgegenhaltungen:
- EP-A- 0 309 755
- EP-A- 0 321 663
- WO-A-86/02127
- DE-A- 2 905 900

## Beschreibung

### Stand der Technik

Die Erfindung geht aus von einem Verfahren zur Ansteuerung eines elektromagnetischen Verbrauchers nach dem ersten Teil des Anspruchs 1, beziehungsweise von einer Einrichtung zur Ansteuerung eines elektromagnetischen Verbrauchers nach dem ersten Teil des Anspruchs 3.

Aus der DE-A-29 05 900 ist eine Vorrichtung zur Steuerung der Entregungszeit von elektromagnetischen Einrichtungen, insbesondere von elektromagnetischen Einspritzventilen bei Brennkraftmaschinen bekannt, bei der der elektromagnetischen Einrichtung eine Schaltungsanordnung mit insbesondere steuerbarer Ausgangsspannung in Reihe oder parallel geschaltet ist. Bei bekannten Vorrichtungen dieser Art wird der induktive Verbraucher beispielhaft aus einer Spannungsquelle über einen in Reihe geschalteten Transistor gespeist, der von Ansteuermitteln ansteuerbar ist. Ein angestrebter schneller Stromabbau beim Abschalten des Transistors kann durch eine parallel zum Transistor geschaltete Zener-Diode, beziehungsweise einen entsprechend betriebenen Transistor mit einer Zener-Spannung erreicht werden, die höher ist als die Betriebsspannung im Augenblick des Abschaltens.

Statt einer separaten Löscheinrichtung kann ein solcher Transistor auch direkt mit einer sogenannten Zener-Klammerung versehen und damit als Löscheinrichtung betrieben werden. Nachteil dieser bekannten Vorrichtung ist, daß die Löscheinrichtung auch dann ungewollt leitend und damit gegebenenfalls unzulässig thermisch beansprucht wird, wenn die Betriebsspannung bei abgeschaltetem Transistor größer wird als die Zener-Spannung. Dies kann beispielsweise bei einem sogenannten Load-Dump-Impuls auf der Betriebsspannungsleitung auftreten.

### Vorteile der Erfindung

Die erfindungsgemäße Lösung mit den im zweiten Teil des Anspruchs 1 bzw. 3 aufgezeigten Merkmalen hat den Vorteil, daß eine drohende Überlastung der Löscheinrichtung erkannt wird und daß durch ein vorbeugendes Umschalten der Löscheinrichtung deren Zerstörung vermeidbar ist. Die Erfindung geht dabei von der Erkenntnis aus, daß eine Zerstörungsgefahr der Löscheinrichtung infolge thermischer Überlastung immer dann droht, wenn im abgeschalteten Zustand des Schaltelementes die Betriebsspannung die Schaltspannung ("Zener-Spannung") der Löscheinrichtung übersteigt. Der erfindungsgemäße Zweck wird dadurch erreicht, daß ein gefährlicher Anstieg der Spannung auf der Betriebsspannungsleitung erkannt und daraus ein Schaltkriterium für das Umschalten der Löscheinrichtung abgeleitet wird. Eine besonders vorteilhafte Einrichtung zur Ansteuerung eines elektromagnetischen Verbrauchers mit einer Serienschaltung des elektromagnetischen Verbrauchers und eines ersten Schaltmittels mit ersten Ansteuermitteln für die Betätigung des Schaltmittels und mit einer Löscheinrichtung umfaßt Spannungsvergleichsmittel und zweite Schaltmittel sowie zweite Ansteuermittel, wobei die Spannungsvergleichsmittel die Betriebsspannung mit einem vorgebbaren Sollwert vergleichen und die zweiten Ansteuermittel die zweiten Schaltmittel zwecks Umschaltung der Löscheinrichtung dann ansteuern, wenn die Betriebsspannung einen vorgebbaren Spannungswert übersteigt.

In einem besonders vorteilhaften Ausführungsbeispiel der Einrichtung ist als Spannungsvergleichsmittel ein Komparator vorgesehen, dessen Eingangsanschlüssen die Betriebsspannung und die Spannung einer Referenzspannungsquelle zugeführt sind.

Besonders zweckmäßig werden als erste und zweite Schaltmittel in den vorgenannten Einrichtungen Transistoren vorgesehen.

Vorzugsweise umfassen die Ansteuermittel für die ersten und zweiten Schaltmittel mindestens einen Mikrorechner.

In einer vorteilhaften Ausführungsform der erfindungsgemäßen Einrichtung umfaßt die Löscheinrichtung eine Serienschaltung mindestens einer Diode und einer Zenerdiode in Verbindung mit dem als Transistor ausgeführten ersten Schaltmittel.

In einer weiteren vorteilhaften Ausgestaltung der erfinderischen Einrichtung umfaßt die Löscheinrichtung weiterhin eine Serienschaltung einer Diode und mehrerer Zener-Dioden und mindestens ein, mindestens einer Zener-Diode parallel geschaltetes zweites Schaltmittel, wodurch im Bedarfsfall durch einen Schaltvorgang der den Zener-Dioden parallel geschalteten Schaltmittel charakteristische Spannungsschwellwerte der Löscheinrichtung stufenweise umschaltbar sind.

### Zeichnung

Ausführungsbeispiele der Erfindung sind in der Zeichnung dargestellt und in der nachfolgenden Beschreibung näher erläutert. Es zeigen Figur 1 einen Stromlaufplan eines ersten Ausführungsbeispiels der Erfindung mit einer umschaltbaren Löscheinrichtung, Figur 2 eine prinzipielle Darstellung einer an sich bekannten Einrichtung mit unterschiedlichen Realisierungsmöglichkeiten von Löscheinrichtungen, Figur 3 ein weiteres Ausführungsbeispiel der Erfindung mit einer Löscheinrichtung, bei der ein charakteristischer Spannungsschwellwert in mindestens einer Stufe schaltbar ist, Figur 4 ein weiteres Ausführungsbeispiel der Erfindung mit einer Löscheinrichtung, bei der ein charakteristischer Spannungsschwellwert der Löscheinrichtung in mehreren Stufen schaltbar ist, Figur 5 ein weiteres Ausführungsbeispiel der Erfindung mit einer umschalt- und abschaltbaren Löscheinrichtung, Figur 6, Figur 7 und Figur 8 Impulsdiagramme über Signalverläufe an charakteristischen Punkten der vorstehend genannten Ausführungsbeispiele.

### Beschreibung der Ausführungsbeispiele

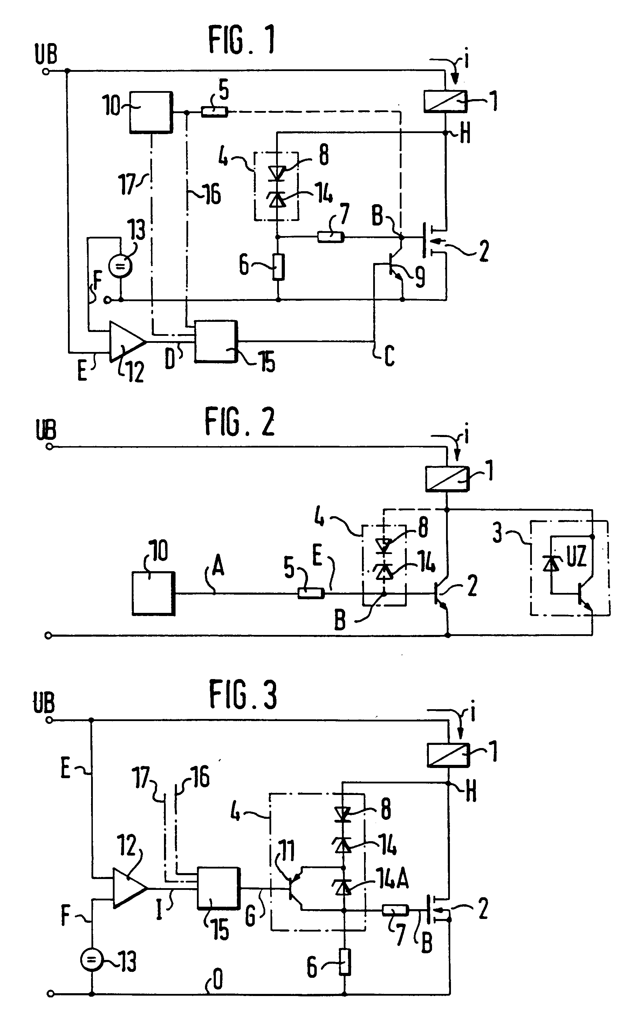

Figur 2 zeigt eine an sich bekannte Einrichtung zur Ansteuerung eines elektromagnetischen Verbrauchers, die einen elektromagnetischen Verbraucher 1, insbesondere ein elektromagnetisches Einspritzventil für eine Brennkraftmaschine und ein damit in Serie geschaltetes Schaltmittel 2, insbesondere einen Transistor umfaßt. Der dem Schaltmittel 2 abgewandte Anschluß des elektromagnetischen Verbrauchers 1 ist mit der Betriebsspannung UB verbunden. Parallel zu dem Schaltmittel 2 ist eine Löscheinrichtung 3 geschaltet, die einen Transistor und eine Zener-Diode umfaßt. Alternativ ist eine Löscheinrichtung 4 vorgesehen, die eine Serienschaltung einer Diode 8 und einer Zener-Diode 14 umfaßt. Die Löscheinrichtung ist zwischen dem Basisanschluß und dem Kollektoranschluß des Transistors 2 geschaltet. Der Steueranschluß (Basisanschluß) des Transistors 2 ist über einen Vorwiderstand 5 mit einem Ansteuermittel 10 verbunden. Beim Abschalten des Transistors 2 wird durch die zuvor beschriebenen Löscheinrichtungen 3 bzw. alternativ 4 ein schneller Stromabbau bewirkt, um möglichst präzise Ansteuerzeiten des elektromagnetischen Verbrauchers 1 zu erreichen. Nachteil dieser bekannten Einrichtung nach Figur 2 ist, daß die Löscheinrichtungen auch dann ungewollt leiten und damit gegebenenfalls unzulässig thermisch beansprucht werden, wenn die Betriebsspannung UB bei abgeschaltetem Transistor 2 größer wird als die charakteristische Schwellspannung (Zener-Spannung) der Löscheinrichtung 3, 4. Dies kann zum Beispiel bei einem sogenannten Load-Dump-Impuls auf der Betriebsspannungsleitung verursacht werden.

Figur 1 zeigt den Stromlaufplan eines ersten Ausführungsbeispiels der Erfindung. Es umfaßt einen elektromagnetischen Verbraucher 1, der in Serie zu einem ersten Schaltelement 2 geschaltet ist. Der dem Schaltelement 2 abgewandte Anschluß des elektromagnetischen Verbrauchers 1 ist mit der Betriebsspannung UB verbunden. Ein Steueranschluß des ersten Schaltmittels 2 ist über die Serienschaltung der Widerstände 6, 7 mit dem Masseanschluß verbunden. Zwischen dem Verbindungspunkt der beiden vorgenannten Widerstände 6, 7 und dem Verbindungspunkt zwischen elektromagnetischem Verbraucher 1 und dem ersten Schaltmittel 2 ist eine Löscheinrichtung 4 geschaltet, die eine Serienschaltung einer Diode 8 und einer Zener-Diode 14 umfaßt. Zwischen dem Steueranschluß des ersten Schaltmittels 2 und dem Masseanschluß ist die Schaltstrecke eines zweiten Schaltmittels 9 geschaltet, dessen Steueranschluß mit dem Ausgangsanschluß zweiter Ansteuermittel 15 verbunden sind. Der Eingangsanschluß der zweiten Ansteuermittel 15 ist mit dem Ausgangsanschluß von Spannungsvergleichsmitteln 12 verbunden, die zwei Eingangsanschlüsse aufweisen.

Gegebenenfalls werden dem zweiten Ansteuermittel 15 auch das Ausgangssignal 16 des ersten Ansteuermittels 10 oder ein weiteres vom ersten Ansteuermittel 10 generiertes Signal 17 zugeführt. Dies ist in Figur 2 strichpunktiert eingezeichnet.

Der erste Eingangsanschluß der Spannungsvergleichsmittel 12 ist mit der Betriebsspannung UB, der zweite Eingangsanschluß mit dem ersten Anschluß einer Referenzspannungsquelle 13 verbunden, deren zweiter Anschluß auf Masse liegt. Weiter eingezeichnet sind erste Ansteuermittel 10, deren Ausgangsanschluß über einen Widerstand 5 mit dem Steueranschluß der ersten Schaltmittel 2 verbunden sind.

Das Ausführungsbeispiel gemäß Figur 3 unterscheidet sich von dem zuvor beschriebenen Ausführungsbeispiel im wesentlichen dadurch, daß die Löscheinrichtung 4 eine Serienschaltung einer Diode 8 und mehrerer Zener-Dioden 14, 14A umfaßt, wobei mindestens einer der Zener-Dioden 14, 14A die Schaltstrecke zweiter Schaltmittel 11 parallel geschaltet ist.

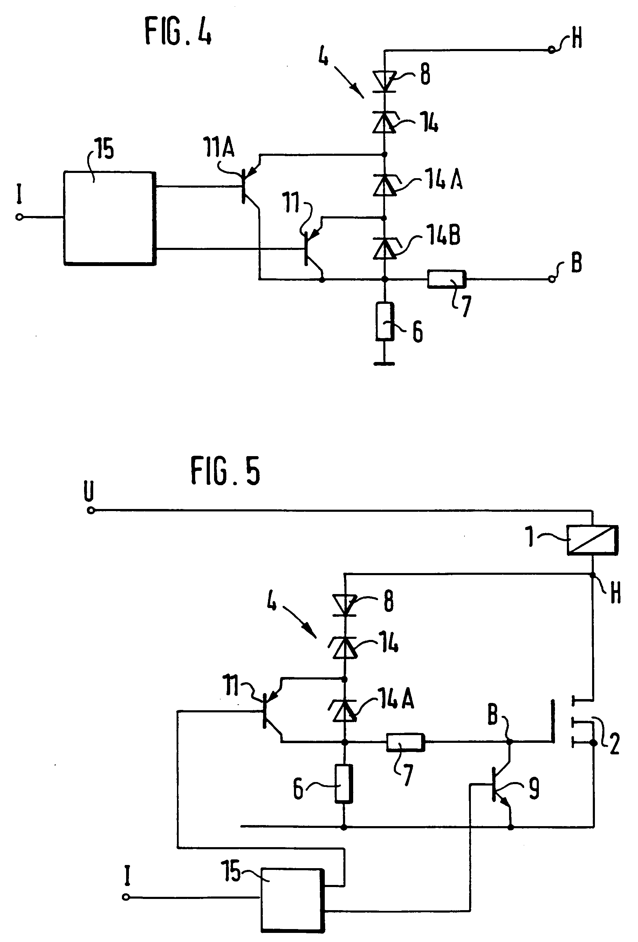

In dem weiteren Ausführungsbeispiel der Erfindung nach Figur 4, die nur noch einen auszugsweise dargestellten Stromlaufplan zeigt, ist wiederum in der Löscheinrichtung 4 eine Serienschaltung mit einer Diode 8 und mehreren Zener-Dioden 14, 14A, 14B vorgesehen, wobei hier mehreren Zener-Dioden 14A, 14B Schaltstrecken zweiter Schaltmittel 11, 11A parallel geschaltet sind.

In dem weiteren Ausführungsbeispiel nach Figur 5, das auch nur als teilweise dargestellter Stromlaufplan gezeigt ist, umfaßt die Löscheinrichtung wieder eine Serienschaltung einer Diode 8 und mehrerer Zener-Dioden 14, 14A, wobei einer Zener-Diode 14A die Schaltstrecke eines zweiten Schaltmittels 11 parallel geschaltet ist. Zusätzlich sind Schaltmittel 9 vorgesehen, über die die Steuerelektrode der ersten Schaltmittel 2 mit Masse verbindbar ist. Die Wirkungsweise der zuvor erläuterten Ausführungsbeispiele wird nachfolgend beschrieben.

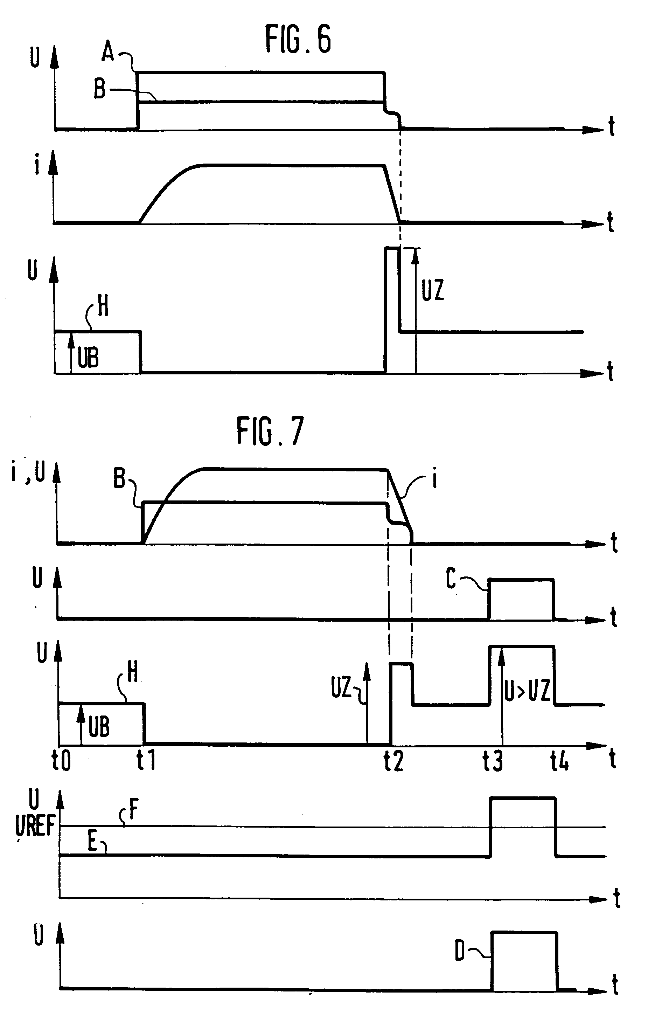

Das Diagramm in Figur 6 zeigt für die an sich bekannte Einrichtung nach Figur 2 die Spannungsverläufe an den Schaltungspunkten A, B, H und den Strom i durch den elektromagnetischen Verbraucher 1, jeweils als Funktion der Zeit t. Der Spannungsverlauf am Schaltungspunkt H zeigt, daß nach Abschalten des elektromagnetischen Verbrauchers 1 durch das Schaltmittel 2 die Spannung durch die Löscheinrichtung 3 bzw. 4 im wesentlichen auf den Spannungswert UZ begrenzt wird, bis der Verbraucherstrom i auf Null abgesunken ist. Anschließend sinkt die Spannung auf den Wert der Versorgungsspannung UB. Wenn nun jedoch auf der Betriebsspannungsleitung sehr hohe Spannungsspitzen auftreten, die die Spannung UZ (Zener-Spannung) wesentlich überschreiten, droht der Löscheinrichtung 3, 4, wie bereits eingangs erwähnt, die Gefahr einer thermischen Überlastung. Diese Gefahr läßt sich bei dem Ausführungsbeispiel der Erfindung gemäß Figur 1 verhindern oder zumindest wesentlich vermindern, wie im folgenden auch unter Bezug auf die Diagramme der Figur 7 ausgeführt wird. Der erste Kurvenverlauf der Figur 7 zeigt die Steuerspannung für den Steuereingang des Schaltmittels 2 am Schaltungspunkt B und den Verlauf des Stroms i durch den elektromagnetischen Verbraucher. Der zweite Kurvenverlauf stellt die Steuerspannung für das zweite Schaltmittel 9 im Schaltungspunkt C dar. Der dritte Kurvenverlauf der Figur 7 zeigt die Spannung U als Funktion der Zeit t am Schaltungspunkt H. Das vierte Teildiagramm der Figur 7 zeigt die konstante Spannung UREF der Referenzspannungsquelle 13, die an dem ersten Eingangsanschluß des Spannungsvergleichsmittels 12 anliegt und die Spannung am Schaltungspunkt E, also an dem zweiten Eingangsanschluß der Spannungsvergleichsmittel 12. Im fünften Teildiagramm der Figur 7 schließlich ist die Spannung U am Schaltungspunkt D dargestellt. Der Spannungsverlauf am Schaltungspunkt H zeigt im Zeitintervall t3, t4 Werte, die die Zener-Spannung UZ wesentlich übersteigen. Diese hohen Spannungswerte U liegen an dem einen Eingangsanschluß der Spannungsvergleichsmittel 12 an und werden von diesem mit der konstanten Referenzspannung UREF der Referenzspannungsquelle 13 verglichen. Im genannten Zeitintervall t3, t4 übersteigt die Spannung U die Spannung der Referenzspannungsquelle, was dazu führt, daß am Ausgangsanschluß der Spannungsvergleichsmittel 12, also am Schaltungspunkt D, ein Steuersignal für den Eingang der zweiten Ansteuermittel 15 zur Verfügung steht, die wiederum den Steuereingang des zweiten Schaltmittels 9 beaufschlagen und dieses zweite Schaltmittel in den leitenden Zustand versetzen. Dadurch wird die Steuerstrecke des ersten Schaltmittels 2 kurzgeschlossen, die Spannungsbegrenzung durch die Löscheinrichtung 3, 4 wird unwirksam und die Spannung am Schaltmittel 2 kann auch höhere Werte annehmen als UZ. Durch eine Verknüpfung des Signals D des Spannungsvergleichsmittels 12 innerhalb des zweiten Ansteuermittels 15 mit dem Ausgangssignal 16 oder einem weiteren, innerhalb des ersten Ansteuermittels 10 erzeugten Signals 17 kann erreicht werden, daß die Spannungsbegrenzung nur in ganz bestimmten Betriebszuständen der Gesamtanordnung unwirksam gemacht wird. So kann das Ansteuern des zweiten Schaltmittels 9 z. B. dann verhindert werden, wenn im Zeitbereich t1, t2 das erste Schaltmittel 2 ohnehin leitend ist und eine Überspannung in der Versorgungsspannung UB damit am Punkt H gar nicht wirksam werden kann.

Der separate Löschtransistor kann entfallen, wenn die beschriebene Einrichtung direkt in die Ansteuerung des ersten Schaltmittels 2 integriert wird. Das Ansteuersignal eines ersten Ansteuermittels 10 kann dann über einen Widerstand 5, wie in Figur 1 gestrichelt dargestellt, der Steuerelektrode des Schaltmittels 2 unmittelbar zugeführt werden. Wie zuvor beschrieben, kann demzufolge die Löscheinrichtung 3, 4 bei gewissen Betriebszuständen der Einrichtung, nämlich z. B. dann, wenn eine unzulässig hohe Spannung auftritt (U > UZ), die eine Gefährdung für die Löscheinrichtung 3, 4 darstellt, vollständig unwirksam gemacht werden.

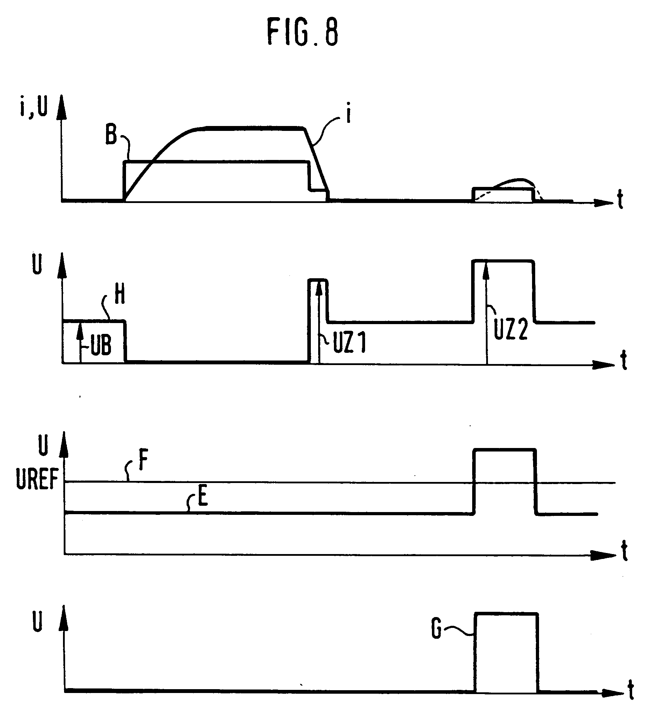

Alternativ ermöglichen die Ausführungsbeispiele der Erfindung nach Figur 3, Figur 4 und Figur 5 auch eine kontrollierte Umschaltung der Löscheinrichtung 3, 4, derart, daß z. B. abhängig von einer von den Spannungsvergleichsmitteln 12 festgestellten höheren Spannung die Löschspannung UZ (Zener-Spannung) zwischen zwei oder gegebenenfalls mehreren Werten umgeschaltet wird. Dies wird auch anhand des Diagramms der Figur 8 erläutert, bei der das erste Teildiagramm die Spannung U am Schaltungspunkt B der Figur 3 und den Strom i durch den elektromagnetischen Verbraucher 1 darstellt. Das zweite Teildiagramm der Figur 8 zeigt die Spannung U am Schaltungspunkt H der Figur 3, das dritte Teildiagramm zeigt die Spannung U am Schaltungspunkt E und die Referenzspannung UREF der Referenzspannungsquelle 13. Das letzte Teildiagramm der Figur 8 schließlich zeigt die Spannung U am Schaltungspunkt G des Ausführungsbeispiels nach Figur 3. Die Löscheinrichtung 4 der Einrichtung nach Figur 3 umfaßt dazu eine Serienschaltung mit einer Diode 8 und mit zwei Zener-Dioden 14, 14A, wobei die zweite Zener-Diode 14A durch ein Schaltmittel 11 überbrückbar ist. Wird dieses Schaltmittel durch Ansteuermittel 15 nach Maßgabe eines Ausgangssignals der Spannungsvergleichsmittel 12 (sowie ggf. weiterer, in Figur 3 nicht dargestellter Signale) angesteuert, dann wird die Spannung am ersten Schaltmittel 2 auf einen niedrigeren Wert begrenzt, als wenn dieses zweite Schaltmittel 11 sich in seinem Sperrzustand befindet. Das Ausführungsbeispiel der Erfindung gemäß Figur 4 unterscheidet sich von dem Ausführungsbeispiel nach Figur 3 im wesentlichen nur dadurch, daß die Löscheinrichtung 4 eine Serienschaltung einer Diode 8 und mehrerer Zener-Dioden 14, 14A, 14B umfaßt, wobei sowohl eine der Zener-Dioden 14B als auch beide Zener-Dioden 14A, 14B durch Schaltmittel 11, 11A in Abhängigkeit von Ausgangssignalen der zweiten Ansteuermittel 15 überbrückbar sind. Dadurch läßt sich die Löschspannung UZ der Löscheinrichtung 4 auf insgesamt drei unterschiedliche Spannungswerte einstellen.

In dem Ausführungsbeispiel nach Figur 5 schließlich ist eine Kombination der Schaltmöglichkeiten für die Löscheinrichtung 4, nach den Ausführungsbeispielen der Figur 1 und Figur 3 bzw. Figur 1 und Figur 4 vorgesehen. Das heißt, durch entsprechende Ansteuersignale der zweiten Ansteuermittel 15 kann wahlweise eine Umschaltung zwischen unterschiedlichen Löschspannungen UZ erfolgen, indem durch das Schaltmittel 11 die Zener-Diode 14A überbrückt wird. Andererseits kann die Begrenzungswirkung der Löscheinrichtung 4 durch Ansteuerung des Schaltmittels 9 auch völlig abgeschaltet werden.

## Patentansprüche

1. Verfahren zur Ansteuerung eines elektromagnetischen Verbrauchers (1) mit einer Serienschaltung des elektromagnetischen Verbrauchers und eines Schaltmittels (2) mit Ansteuermitteln (10) zur Betätigung des Schaltmittels (2) und mit einer Löscheinrichtung (3, 4) für die Aufnahme eines bei Abschaltung des elektromagnetischen Verbrauchers (1) durch das Schaltmittel (2) entstehenden Spannungsimpulses, bei dem die an der Löscheinrichtung (3, 4) anliegende Spannung erfaßt, die erfaßte Spannung mit mindestens einem vorgebbaren Sollwert verglichen wird, und in Abhängigkeit von einem festgestellten Überschreiten des Sollwertes, die Löscheinrichtung (3, 4) umgeschaltet wird, dadurch gekennzeichnet, daß der Löscheinrichtung (3, 4) durch die Umschaltung ein höherer Spannungsschwellwert der Löschspannung zugeordnet wird.

2. Verfahren nach Anspruch 1, dadurch gekennzeichnet, daß die Löscheinrichtung (3, 4) umgeschaltet wird, wenn die Spannung an der Löscheinrichtung (3, 4) bei gesperrtem Schaltmittel (2) einen vorgebbaren Grenzwert übersteigt.

3. Einrichtung zur Ansteuerung eines elektromagnetischen Verbrauchers (1) mit einer Serienschaltung des elektromagnetischen Verbrauchers (1) und eines ersten Schaltmittels (2) mit ersten Ansteuermitteln (10) für die Betätigung des Schaltmittels (2) und mit einer Löscheinrichtung (3, 4) für die Aufnahme eines bei Abschaltung des elektromagnetischen Verbrauchers (1) durch das Schaltmittel (2) entstehenden Spannungsimpulses, wobei die Einrichtung Spannungsvergleichsmittel (12), zweite Schaltmittel (9, 11, 11A) und zweite Ansteuermittel (15) umfaßt, wobei die Spannungsvergleichsmittel (12) die Betriebsspannung (UB) mit einem vorgebbaren Sollwert (UREF) vergleichen und die zweiten Ansteuermittel (15) die zweiten Schaltmittel (9, 11, 11A) zwecks Umschaltung der Löscheinrichtung (3, 4) dann ansteuern, wenn die Betriebsspannung (UB) den vorgegebenen Sollwert übersteigt, dadurch gekennzeichnet, daß die Umschaltung auf höhere Spannungsschwellwerte der Löschspannung vorgenommen wird.

4. Einrichtung nach Anspruch 3, dadurch gekennzeichnet, daß als Spannungsvergleichsmittel (12) ein Komperator vorgesehen ist, dessen Eingangsanschlüssen die Betriebsspannung (UB) und die Spannung (UREF) einer Referenzspannungsquelle (13) zugeführt sind.

5. Einrichtung nach einem der Ansprüche 3,4 , dadurch gekennzeichnet, daß als Schaltmittel (2, 9, 11, 11A) Transistoren vorgesehen sind.

6. Einrichtung nach einem der Ansprüche 3 bis 5, dadurch gekennzeichnet, daß die Ansteuermittel (10, 15) für die Schaltmittel (2, 9, 11, 11A) mindestens einen Mikrorechner umfassen.

7. Einrichtung nach einem der Ansprüche 3 bis 6, dadurch gekennzeichnet, daß die Löscheinrichtung (3, 4) eine Serienschaltung einer Diode (8) und mehrerer Zener-Dioden (14, 14A, 14B) und mindestens ein, mindestens einer Zener-Diode (14, 14A, 14B) parallel geschaltetes zweites Schaltmittel (11, 11A) umfaßt.

## Claims

1. A method for driving an electromagnetic consumer (1) having a series circuit formed by the electromagnetic consumer and a switching means (2) with driving means (10) for activating the switching means (2) and having a quenching device (3, 4) for accepting a voltage pulse occurring when the electromagnetic consumer (1) is switched off by the switching means (2), in which the voltage on the quenching device (3, 4) is determined, the determined voltage is compared with at least one presettable desired value and, as a function of a defined overshoot of the desired value, the quenching device (3, 4) is switched over, wherein a relatively higher voltage threshold value of the quenching voltage is assigned to the quenching device (3, 4) via the switch-over.

2. The method as claimed in claim 1, wherein in the case of a switched-off switching means (2) the quenching device (3, 4) is switched over when the voltage on the quenching device (3, 4) rises above a presettable limit value.

3. A device for driving an electromagnetic consumer (1) having a series circuit formed by the electromagnetic consumer (1) and a first switching means (2) with driving means (10) for activating the switching means (2) and having a quenching device (3, 4) for accepting a voltage pulse occurring when the electromagnetic consumer (1) is switched off by the switching means (2), the device comprising voltage comparison means (12), second switching means (9, 11, 11A) and second driving means (15), the voltage comparison means (12) comparing the operating voltage (UB) with a presettable desired value (UREF) and the second driving means (15) then driving the second switching means (9, 11, 11A) for the purpose of switching over the quenching device (3, 4) when the operating voltage (UB) rises above the preset desired value, wherein the switch-over is undertaken to higher voltage threshold values.

4. The device as claimed in claim 3, wherein as voltage comparison means (12) a comparator is provided, to the input connections of which the operating voltage (UB) and the voltage (UREF) of a reference voltage source (13) are fed.

5. The device as claimed in one of claims 3 or 4, wherein transistors are provided as switching means (2, 9, 11, 11A).

6. The device as claimed in one of claims 3 to 5, wherein the driving means (10, 15) for the switching means (2, 9, 11, 11A) comprise at least one microprocessor.

7. The device as claimed in one of claims 3 to 6, wherein the quenching device (3, 4) comprises a series circuit formed by a diode (8) and a plurality of Zener diodes (14, 14A, 14B) and at least one second switching means (11, 11A) connected in parallel with at least one Zener diode (14, 14A, 14B).

## Revendications

1. Procédé de commande d'un consommateur électromagnétique (1) avec un montage en série du consommateur électromagnétique et d'un moyen de commutation (2) ayant des moyens de commande (10) pour actionner le moyen de commutation (2) et une installation d'extinction (3, 4) pour recevoir l'impulsion de tension créée lors de la coupure du consommateur électromagnétigue (1) par le moyen de commutation (2), en recevant la tension appliquée à l'installation d'extinction (3, 4), pour la comparer à au moins un seuil de consigne prédéterminé et pour commuter en fonction d'un dépassement constaté de la valeur de consigne, l'installation d'extinction (3, 4), procédé caractérisé en ce que par commutation, on attribue une valeur de seuil de tension plus élevée de la tension d'extinction à l'installation d'effacement (3, 4).

2. Procédé selon la revendication 1, caractérisé en ce que l'installation d'extinction (3, 4) est commutée lorsque la tension dans l'installation d'extinction (3, 4) dépasse un seuil prédeterminé, le moyen de commutation (2) étant bloqué.

3. Installation de commande d'un consommateur électromagnétique (1) avec un montage en série d'un consommateur électromagnétique (1) et d'un premier moyen de commutation (2) avec des premiers moyens de commande (10) pour actionner le moyen de commutation (2) et une installation d'effacement (3, 4) pour recevoir une impulsion de tension crée à la coupure du consommateur électromagnétique (1) par le moyen de commutation (2), l'installation comprenant des comparateurs de tension (12), des seconds moyens de commutation (9, 11, 11A) et des seconds moyens de commande (15), les comparateurs de tension (12) comparant la tension de fonctionnement (UB) à un seuil prédéterminé (UREF) et les seconds moyens de commande (15) commandent les seconds moyens de commutation (9, 11, 11A) pour commuter l'installation d'effacement (3, 4) lorsque la tension de fonctionnement (UB) dépasse la valeur de seuil prédéterminée, installation caractérisée en ce que la commutation se fait avec des valeurs de seuil de tensions plus élevées pour la tension d'extinction.

4. Installation selon la revendication 3, caractérisée en ce que le comparateur de tension (12) est un comparateur dont les entrées reçoivent la tension de fonctionnement (UB) et la tension (UREF) d'une source de tension de référence (13).

5. Installation selon l'une des revendications 3, 4, caractérisée en ce que les moyens de commutation (2, 9, 11, 11A) sont des transistors.

6. Installation selon l'une des revendications 3 à 5, caractérisée en ce que les moyens de commande (10, 15) des moyens de commutation (2, 9, 11, 11A) comprennent au moins un microcalculateur.

7. Installation selon l'une des revendications 3 à 6, caractérisée en ce que l'installation d'effacement (3, 4) comprend un montage en série d'une diode (8) et de plusieurs diodes Zener (14, 14A, 14B) et au moins un second moyen de commutation (11, 11A) branché en parallèle sur au moins une diode Zener (14, 14A, 14B).
